(19) Europäisches Patentamt
European Patent Office
Office européen des brevets

(11) EP 0 432 599 B1

(12) EUROPÄISCHE PATENTSCHRIFT

(45) Veröffentlichungstag und Bekanntmachung des Hinweises auf die Patenterteilung:
**19.03.1997 Patentblatt 1997/12**

(51) Int Cl.6: **G03F 7/039**

(21) Anmeldenummer: **90123055.7**

(22) Anmeldetag: **01.12.1990**

# (54) Strahlungsempfindliches Gemisch und Verfahren zur Herstellung von Reliefstrukturen

Light-sensitive composition, and process for the formation of relief patterns

Composition photosensible et procédé pour la fabrication de structures en relief

(84) Benannte Vertragsstaaten:
**BE DE FR GB IT NL**

(30) Priorität: **12.12.1989 DE 3940965**

(43) Veröffentlichungstag der Anmeldung:
**19.06.1991 Patentblatt 1991/25**

(73) Patentinhaber: **BASF Aktiengesellschaft**
**67063 Ludwigshafen (DE)**

(72) Erfinder: **Nguyen Kim, Son, Dr.**
**W-6944 Hemsbach (DE)**

(56) Entgegenhaltungen:
**EP-A- 0 282 724** **EP-A- 0 297 443**
**EP-A- 0 342 498** **FR-A- 2 389 155**

- **Theodora W. Greene "Protective Groups in Organic Synthesis" S.21ff**

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 432 599 B1

## Beschreibung

Die Erfindung betrifft strahlungsempfindliche Gemische, die negativ arbeitend sind, ein in Wasser unlösliches, in wäßrig-alkalischen Lösungen lösliches Bindemittel, eine unter Einwirkung von Strahlung eine Säure bildende Verbindung und Gruppierungen, die durch säurekatalytische Einwirkung mit dem Bindemittel bei erhöhter Temperatur zur Vernetzung führen, enthalten. Diese Gemische sind sensitiv gegenüber UV-, Elektronen- und Röntgenstrahlen und eignen sich besonders als Resistmaterial.

Negativ arbeitende strahlungsempfindliche Gemische sowie Verfahren zur Bildherstellung mittels dieser Gemische sind bekannt. Unter negativ arbeitenden Photoresists werden dabei solche verstanden, bei denen nach der bildmäßigen Belichtung der lichtempfindlichen Schicht die belichteten Bereiche dieser Schicht, gegebenenfalls nach einer zusätzlichen Wärmebehandlung, in der Entwicklerlösung, in der sie vor der Belichtung löslich waren, unlöslich sind.

Im allgemeinen basieren negativ arbeitende Photoresists auf photopolymerisierbaren Gemischen, die neben einem polymeren Bindemittel eine photopolymerisierbare Verbindung und einen Photoinitiator enthalten. Die am meisten verwendeten negativ arbeitenden Photoresists für die Herstellung integrierter Schaltungen enthalten fast ausnahmslos partiell cyclisiertes Polyisopren als vernetzbare Komponente und eine Diazid-Verbindung als lichtempfindlichen difunktionellen Vernetzer. Als Diazide sind hierbei solche der Struktur (A)

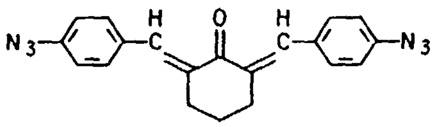

(A)

sehr gebräuchlich.

Neuerdings sind auch negativ arbeitende Photoresists, die aus teilcyclisiertem Polybutadien und Diaziden bestehen, im Handel erhältlich (vgl. auch Harita, Y., Ichigawa, M., Harada, K., Polym. Eng. Sci., 17 (1977), 372).

Eine Reihe negativ arbeitender Photoresists basiert auch auf der Photodimerisierung als Vernetzungsreaktion. Hierher gehören die Zimtsäurederivate und die ihnen im Aufbau verwandten Chalkone. Die Vernetzungsreaktion verläuft im wesentlichen als lichtinduzierte [2+2]-Cycloaddition unter Bildung von Cyclobutanen (vgl. Williams, J.L.R.: Fortschr. Chem. Forsch., 13 (1969), 227; Reiser, A., Egerton, P.L.: Photogr. Sci. Eng., 23 (1979), 144; M. Kato et al: J. Polym. Sci. part B, Polym. Lett. Ed. 8 (1970), 263; M. Kato et al: Photogr. Sci. Eng., 23 (1979), 207).

In den letzten Jahren hat auch noch ein schon längere Zeit bekannter Typ photodimerisierbarer Epoxidharze als Photoresist Verwendung gefunden (vgl. z.B. DE-A-14 47 016; DE-A-23 42 407; DE-A-25 53 346 sowie DE-A-24 49 926). Diese Harze tragen sowohl Gruppierungen, die Photocycloadditionen ermöglichen, z.B. Chalkonreste, als auch Epoxygruppen, die thermisch katalysiert nachvernetzt werden können (vgl. Photoresist, New York,: McGraw Hill (1975); GB-PS 892 111 und US-PS 2 852 379).

Außer den negativ arbeitenden Photoresisten, die ein Diazid der oben genannten Struktur (A) enthalten, sind die Photoreaktionen nur im NUV-Bereich (d.h. bei 350 bis 450 nm) möglich. Neue Diazidverbindungen für den kurzwelligen UV-Bereich wurden in den letzten Jahren beschrieben. Dazu gehören Ketonverbindungen (vgl. J. Elektrochem. Soc. 128 (1981), 361) sowie schwefelhaltige Diazidverbindungen (vgl. J. Elektrochem. Soc., 127 (1980), 2759).

Auch negativ arbeitende wäßrig-alkalisch entwickelbare Photoresists, die im kurzwelligen UV strukturierbar sind, sind bekannt. Hierzu werden Poly(p-vinylphenol) als Bindemittel und 3,3'-Diazidodiphenylsulfon verwendet (vgl. IEEE Trans. Electron Devices, ED. 28 (1981), 1306; IEEE Trans. Electron Devices, ED-28 (1981), 1284). Ein weiterer wäßrig-alkalisch entwickelbarer negativ arbeitender Photoresist basiert auf einem Oniumsalz und Methylacrylamidoglycolatmethylether (vgl. Hult et al; Polymers for high Tech. ACS Symposium Series 346 (1987), 162 bis 169), der auf dem Prinzip der säurekatalytischen Selbst-Kondensation zur Vernetzung des Bindemittels beruht.

Eine weitere photopolymerisierbare Zusammensetzung, die auf einem säurehärtbaren Material und einem Jodoniumalz als Säurespender basiert, ist aus der DE-A-2 602 574 bekannt.

Auch säurekatalytische Vernetzer, zu denen beispielsweise die als Zwischenprodukte bei der Kondensation von Phenol/Formaldehyd-Harz erhältlichen Arylmethylolverbindungen gehören, waren bereits bekannt (vgl. Progr. Org. Coat. 9 (1981), 107; DE-A-29 04 961; Plastics and Rubber Processing and Application 1 (1981), 39; DE-A-32 47 754; EP-A-01 39 309; JP 3051424-A). Auch für photostrukturierbares Aufzeichnungsmaterial hat dieser säurekatalytische Vernetzer Anwendung gefunden. In EP-A-0282724 wird über ein neues negativ arbeitendes System, das auf Poly(p-hydroxystyrol), einem Säurespender und einem Vernetzer mit mindestens zwei geschützten Methylolgruppen basiert, berichtet; anstelle Poly(p-hydroxystyrol) kann auch m-Kresol-Formaldehyd-Harz eingesetzt werden. Analog wurde in WO-A-88/02878 ein anderes Negativ-System beschrieben, in dem auch Poly(p-hydroxystyrol) oder m-Kresol-Formaldehyd-Novolake als Bindemittel, ein 1,2-Chinondiazid als Säurespender und ein 2,6-Dimethylol-p-Kresol als Vernetzer eingesetzt wird (vgl. auch Photopolymers, Principles-Processes and Materials, 63-72 (1988)). Nachteile der beiden

obengenannten Systeme sind: Haftungsabfall bei überbelichtung und Restschichtbildung, bzw. zu geringe Empfindlichkeit.

Aus der DE-A-23 06 248 und der EP-A-03 02 359 waren bereits strahlungsempfindliche Stoffgemische bekannt, die Acetalgruppierungen enthalten, die hier als Inhibitoren für positiv arbeitende Aufzeichnungsmaterialen eingesetzt werden.

Die EP 0 342 498-A3 betrifft positiv und negativ arbeitende strahlungsempfindliche Gemische, die Umsetzungsprodukte von phenolische Hydroxylgruppen enthaltenden Polymeren mit Dihydropyran oder Alkylvinylethern und eine organische Verbindung, deren Löslichkeit in wäßrig-alkalischem Entwickler durch Einwirkung von Säure erhöht wird und die mindestens eine durch Säure spaltbare Gruppierung enthält, sowie eine zusätzliche Gruppierung, die unter Einwirkung von Strahlung eine starke Säure bildet, enthalten.

Aufgabe der vorliegenden Erfindung war es, neue hochaktive strahlungsempfindliche Systeme für die Herstellung von im kurzwelligen UV lichtempfindlichen Schichten aufzuzeigen, die sich mit wäßrig-alkalischen Lösungen entwickeln lassen und Strukturen im Submikronbereich herzustellen erlauben, die thermisch und gegenüber Plasma stabil sind.

Überraschenderweise läßt sich diese Aufgabe sehr vorteilhaft durch die Einbeziehung von bestimmten mehrfunktionellen Aldehydacetalen lösen.

Gegenstand der vorliegenden Erfindung ist ein strahlungsempfindliches Gemisch, im wesentlichen bestehend aus

(a) einem in Wasser unlöslichen, in wäßrig-alkalischen Lösungen löslichen Bindemittel oder Bindemittelgemisch und

(b) einer bei Bestrahlung eine starke Säure bildenden Verbindung,

das dadurch gekennzeichnet ist, daß Komponente (a) mindestens eine Gruppierung

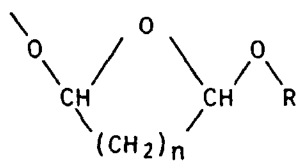

(I)

worin R für Alkyl mit 1 bis 5 Kohlenstoffatomen steht und n = 2,3 oder 4, enthält.

Als Komponente (a) wird vorzugsweise ein phenolisches Harz eingesetzt, dessen ortho- und/oder para-Stellungen an den Phenylresten zu mindestens 20 % frei von Substituenten sind, sowie ein Gemisch aus einem phenolischen Harz, dessen ortho- und/oder para-Stellungen an den Phenylresten zu mindestens 20 % frei von Substituenten sind, und einem davon verschiedenen Novolak.

Insbesondere kommt als Komponente (a) Poly-(p.-hydroxistyrol) oder Poly(p-hydroxi-α-methylstyrol mit mittleren Molekulargewichten $\overline{M}_W$ zwischen 200 und 200.000, wobei ein Teil der Hydroxylgruppen durch Reste der Gruppierung (I) ersetzt ist, in Betracht.

Beispiele für Komponente (a) sind auch solche, worin mindestens 5, vorzugsweise 20 bis 60 mol.-% der das Bindemittel (a) aufbauenden Monomereinheiten Gruppierung (I) aufweisen.

Bevorzugt sind auch solche erfindungsgemäßen strahlungsempfindlichen Gemische, deren Bindemittel (a) Gruppierungen (II) und (III)

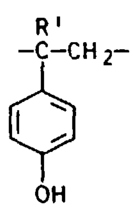

und

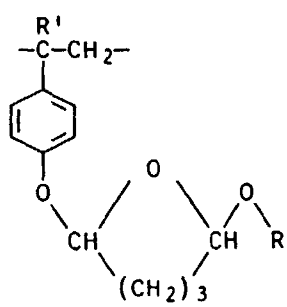

(II) (III)

enthält, wobei R die oben angegebene Bedeutung hat und R' für H oder $CH_3$ steht.

Im erfindungsgemäßen strahlungsempfindlichen Gemisch ist im allgemeinen Komponente (a) in einer Menge von 50 bis 99 Gew.-% und Komponente (b) in einer Menge von 1 bis 50 Gew.-% enthalten.

Als Komponente (b) kommen vorzugsweise Sulfonium- oder Jodoniumsalze der allgemeinen Formeln (IV) oder (V)

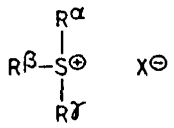

(IV)

oder

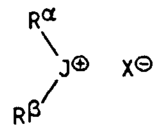

(V)

,

in Betracht, worin $R^{\alpha}$, $R^{\beta}$ $R^{\gamma}$ untereinander gleich oder verschieden sind und für Alkyl mit 1 bis 3 Kohlenstoffatomen, Aryl, substituiertes Aryl oder Aralkyl stehen und $X^{\ominus} = ClO4^{\ominus}$ , $AsF_6^{\ominus}$, $SbF_6^{\ominus}$, $PF_6^{\ominus}$ und/oder $CF_3SO_3^{\ominus}$ ist, insbesondere solche, in denen mindestens einer der Reste $R^{\alpha}$**,** $R^{\beta}$ und $R^{\gamma}$ für einen Rest der allgemeinen Formel (VI)

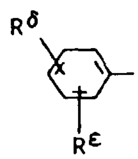

(VI)

steht, worin $R^{\delta}$ und $R^{\varepsilon}$ untereinander gleich oder verschieden sind und für H, OH, Alkyl oder Alkoxi mit jeweils 1 bis 4 Kohlenstoffatomen,

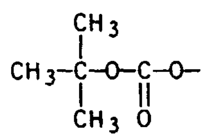

,

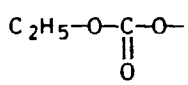

oder

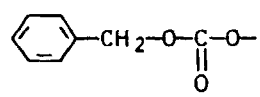

stehen.

Das erfindungsgemäße strahlungsempfindliche Gemisch kann außerdem zusätzlich einen Sensibilisator enthalten, der Strahlung absorbiert und auf Komponente (b) überträgt.

Gegenstand der vorliegenden Erfindung ist auch ein Verfahren zur Herstellung lichtempfindlicher Beschichtungsmaterialien, sowie ein Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 130°C, bildmäßiges Belichten, Erhitzen auf Temperaturen von 70 bis 160°C und Entwickeln mit einer wäßrig-alkalischen Lösung, wobei erfindungsgemäße strahlungsempfindliche Gemische eingesetzt werden.

Gegenstand der vorliegenden Erfindung ist außerdem ein Verfahren zur Herstellung von als Bindemittel (a) in den erfindungsgemäßen strahlungsempfindlichen Gemischen geeigneten phenolischen Harzen, die Gruppierungen der Formel

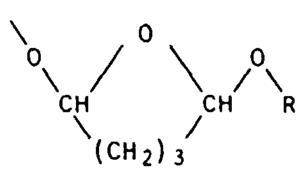

(I)

worin R für Alkyl mit 1 bis 5 Kohlenstoffatomen steht, enthalten, das dadurch gekennzeichnet ist, daß phenolische Harze, die freie phenolische Hydroxylgruppen aufweisen, mit 3,4-Dihydro-2-alkoxipyran, das 1 bis 5 Kohlenstoffatome in der Alkoxigruppe enthält, unter Säurekatalyse umgesetzt werden.

Die erfindungsgemäßen strahlungsempfindlichen Gemische zeichnen sich durch hohe Empfindlichkeit sowie gute Struktureigenschaften, insbesondere sehr gute Haftung auf Siliciumoxidoberflächen aus.

Zu den strahlungsempfindlichen Gemischen, ihren Aufbaukomponenten und ihrer Verwendung ist im einzelnen folgendes auszuführen.

a) Als in Wasser unlösliche, in wäßrig-alkalischen Lösungen lösliche Bindemittel kommen in Frage phenolische Harze, bevorzugt solche, deren ortho- und/oder para-Stellungen an den Phenylresten zu mindestens 20 %, vorzugsweise bis zu 66 %, frei von Substituenten sind, wie z. B. Novolake mit mittleren Molekulargewichten $\overline{M}_W$ zwischen 300 und 20 000, vorzugsweise zwischen 500 und 5000, beispielsweise Novolake auf Basis von p-Kresol/Formaldehyd, insbesondere Poly-(p-hydroxistyrole), Poly(p-hydroxi-$\alpha$-methylstyrole), beispielsweise mit mittleren Molekulargewichten $\overline{M}_W$ zwischen 200 und 200 000, vorzugsweise 5000 bis 40 000, sowie Gemische derartiger phenolischer Harze.

Als Novolake kommen beispielsweise auch solche Novolake in Frage, wie sie in Novolak Resins Used in Positiv Resist Systems von T. Pampalone in Solid State Technology, June 1984, Seite 115 bis 120, beschrieben sind. Für spezielle Anwendungen, z. B. für Belichtung im kurzwelligen UV-Gebiet kommen bevorzugt Novolake aus p-Kresol und Formaldehyd in Frage.

Bevorzugt als Komponente (a) sind solche, die Gruppierung (II) und (III) enthalten, d.h. aus polymerisierte Einheiten von phenolischen Monomeren mit freier ortho- und/oder para-Stellung, z. B. p-Hydroxistyrol, und polymerisierten Einheiten mindestens eines davon verschiedenen Vinylmonomeren, das die Gruppierung (I) enthält, bestehen.

Derartige Produkte lassen sich nach üblichen Methoden herstellen, beispielsweise indem man phenolische Polymere mit 3,4-Dihydro-2-methoxipyran unter Säurekatalyse reagieren läßt.

Die erfindungsgemäßen strahlungsempfindlichen Gemische enthalten Komponente (a) im allgemeinen in Mengen von 50 bis 99, vorzugsweise 85 bis 97 Gewichtsprozent der Gesamtmenge der Komponenten (a) + (b).

Als Säurespender (b) eignen sich alle Verbindungen, welche unter Bestrahlung eine starke Säure bilden. Bevorzugt zur kurzwelligen Bestrahlung sind jedoch Sulfoniumsalze der allgemeinen Formel (IV)

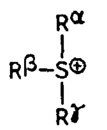 $X^{\ominus}$ (IV),

worin $R^{\alpha}$, $R^{\beta}$ und $R^{\gamma}$ untereinander gleich oder verschieden sind und für Alkyl mit 1 bis 3 Kohlenstoffatomen wie z.B. Methyl, Ethyl, Aryl, wie z.B Phenyl, substituiertes Aryl, wie z.B. substituiertes Phenyl, oder Aralkyl, wie z.B. Benzyl, stehen, und $X^{\ominus}$ = $AsF_6^{\ominus}$, $SbF_6^{\ominus}$, $PF_6^{\ominus}$, $ClO_4^{\ominus}$, $BF_4^{\ominus}$ und/oder $CF_3SO_3^{\ominus}$ (= Triflat).

Von diesen Sulfoniumsalzen bevorzugt sind solche der allgemeinen Formel (IV), in denen mindestens einer der Reste $R^{\alpha}$, $R^{\beta}$ und $R^{\gamma}$ den Rest (VI)

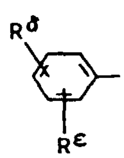 (VI)

bedeutet, worin $R^{\delta}$ und $R^{\varepsilon}$ untereinander gleich oder verschieden sind und für H, OH, Alkyl oder Alkoxi mit 1 bis 4 Kohlenstoffatomen, wie z.B. Methyl, Ethyl, Acyl, wie z. B.

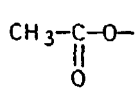

oder einen der Reste

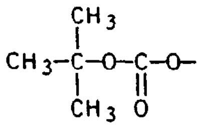 , 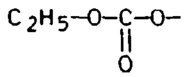 , oder 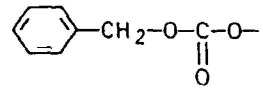 ,

stehen.

Beispiele für geeignete Sulfoniumsalze sind Triphenylsulfoniumhexafluoroarsenat oder -phosphat und Dimethyl-4-hydroxiphenylsulfoniumtriflat oder -hexafluoroarsenat.

Auch andere Säurespender können als Komponente (b) eingesetzt werden, beispielsweise Jodoniumverbindungen der oben angegebenen allgemeinen Formel (V).

Komponente (b) ist im erfindungsgemäßen strahlungsempfindlichen Gemisch im allgemeinen in Mengen von 1 bis 50, vorzugsweise 3 bis 15 Gewichtsprozent, bezogen auf die Gesamtmenge der Komponenten (a) + (b) enthalten.

Die erfindungsgemäßen Gemische werden bevorzugt in einem organischen Lösungsmittel gelöst, wobei der Feststoffgehalt im allgemeinen im Bereich zwischen 5 und 40 Gew.-% liegt. Als Lösungsmittel kommen bevorzugt aliphatische Ketone, Ether, sowie Mischungen derselben in Frage, besonders Ethyl-cellosolve, Butylglykol, Methyl-cellosolve und 1-Methoxy-2-propanol, Alkylenglykol-alkylether-ester, wie beispielsweise Methyl-cellosolve-acetat, Ethyl-cellosolve-acetat, Methyl-propylenglykol-acetat und Ethyl-propylenglykol-acetat, Ketone wie beispielsweise Cyclohexanon, Cyclopentanon und Methyl-ethyl-keton sowie Acetate, wie Butylacetat und Aromaten, wie Toluol und Xylol. Die Auswahl der entsprechenden Lösungsmittel, sowie deren Mischung richtet sich nach der Wahl des jeweiligen phenolischen Polymers, Novolaks und der photoempfindlichen Komponente.

Weiterhin können andere Zusätze wie Haftvermittler , Netzmittel, Farbstoffe und Weichmacher zugesetzt werden.

Gegebenenfalls können auch Sensibilisatoren in geringen Mengen zugesetzt werden, um die Verbindungen im längerwelligen UV- bis hin zum sichtbaren Bereich zu sensibilisieren. Polycyclische Aromaten, wie Pyren und Perylen sind dafür bevorzugt, jedoch können auch andere Farbstoffe, die als Sensibilisatoren wirken, verwendet werden.

Die Lösung des erfindungsgemäßen strahlungsempfindlichen Gemisches kann durch ein Filter mit einem Porendurchmesser von 0,2 µm filtriert werden.

Durch Aufschleudern der Resistlösung bei Umdrehungszahlen zwischen 1000 und 10 000 U/min wird ein Resistfilm einer Schichtdicke von 0,1 bis 5 µm auf einem Wafer (z.B. ein an der Oberfläche oxidierter Silicium-Wafer) erzeugt. Der Wafer wird dann zwischen 1 und 5 Minuten bei 90°C bzw. 80°C getrocknet (z.B. auf einer Heizplatte).

Die in den folgenden Beispielen angegebenen Teile und Prozente sind, soweit nicht anders angegebenen, Gewichtsteile bzw. Gewichtsprozente.

Herstellung von acetalhaltigem Poly(p-hydroxystyrol)

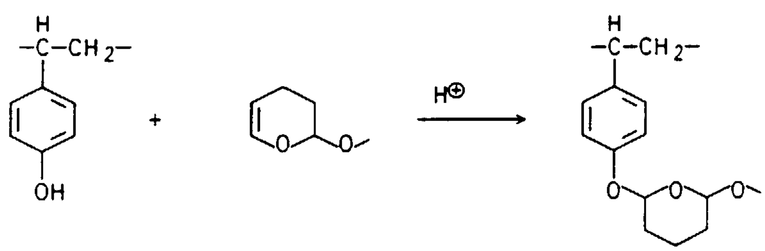


10 Teile Poly(p-Hydroxistyrol) (= kommerz. Produkt der Fa. Polysciences Inc., $\overline{M}_W$ 1500-7000), und 15 Teile 3,4-Dihydro-2-methoxy-2H-pyran wurden in 100 Teilen Essigester gelöst. Nach Zugabe von 0,1 bis 0,5 Teilen konz. HCl (36 %ig) wurde der Ansatz 1 Stunde lang gerührt und über Nacht bei Raumtemperatur stehengelassen. Nach der Neutralisation mit $NaHCO_3$-Lösung wurde die organische Phase abgetrennt und bei einer Temperatur von 25 bis 70°C unter Vakuum eingedampft. Das Polymer wurde in 100 Teilen Essigester gelöst, in 2000 Teilen Ligroin gefällt und abgesaugt.

Beispiel 1

Eine Photoresistlösung wird aus 95 Teilen des oben beschriebenen acetalhaltigen Poly(p-hydroxistyrol), 5 Teilen Triphenylsulfoniumhexafluoroarsenat und 280 Teilen Cyclohexanon hergestellt. Die Lösung wird anschließend durch einen Filter mit einem Porendurchmesser von 0,2 µm filtriert.

Die Resistlösung wird auf einen oxidierten Siliciumwafer in 1 µm Schichtdicke aufgeschleudert. Der so beschichtete Wafer wird dann eine Minute bei 90°C getrocknet und anschließend durch eine Testmaske im Kontaktverfahren mit Excimer-Laser der Wellenlänge λ = 248 nm belichtet. Die Belichtungsenergie beträgt 15 mJ/cm². Danach wird bei

120°C 1 Minute ausgeheizt und mit einem Entwickler von pH-Wert 12,0 bis 14,00 entwickelt.

Beispiel 2

Eine Photoresistlösung wird aus 95 Teilen des oben beschriebenen acetalhaltigen Poly(p-hydroxistyrol), 5 Teilen Diphenyljodoniumhexafluorophosphat und 280 Teilen Cyclohexanon hergestellt.

Es wird wie in Beispiel 1 verfahren. Die Empfindlichkeit für 1 µm-Schichtdicke beträgt 45 mJ/cm$^2$.

Triphenylsulfonium-hexafluoroarsenat und Diphenyljodoniumhexafluorophosphat sind kommerzielle Produkte der Fa. Alfa.

Beispiel 3

Eine Photoresistlösung wird aus 92 Teilen des oben beschriebenen acetalhaltigen Poly(p-hydroxystyrol) 8 Teilen Dimethyl-(p-hydroxyphenyl)-sulfoniumtriflat und 280 Teilen Ethylglykolacetat hergestellt. Es wird wie in Beispiel 1 verfahren. Die Empfindlichkeit für 1 µm-Schichtdicke beträgt 35 mJ/cm$^2$.

## Patentansprüche

**1.** Strahlungsempfindliches Gemisch, im wesentlichen bestehend aus

(a) einem in Wasser unlöslichen, in wäßrig-alkalischen Lösungen löslichen Bindemittel oder Bindemittelgemisch
und
(b) einer bei Bestrahlung eine starke Säure bildenden Verbindung,

dadurch gekennzeichnet, daß Komponente (a) mindestens eine Gruppierung (I)

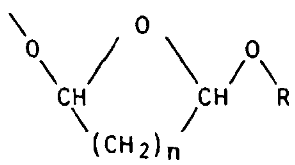

(I)

worin R für Alkyl mit 1 bis 5 Kohlenstoffatomen steht und n = 2, 3 oder 4, enthält.

**2.** Strahlungsempfindliches Gemisch nach Anspruch 1, dadurch gekennzeichnet, daß als Komponente (a) ein phenolisches Harz eingesetzt wird, dessen ortho- und/oder para-Stellungen an den Phenylresten zu mindestens 20 % frei von Substituenten sind.

**3.** Strahlungsempfindliches Gemisch nach einem der vorhergehenden Ansprüche, dadurch gekennzeichnet, daß als Komponente (a) ein Gemisch aus einem phenolischen Harz, dessen ortho- und/oder para-Stellungen an den Phenylresten zu mindestens 20 % frei von Substituenten sind, und einem davon verschiedenen Novolak eingesetzt wird.

**4.** Strahlungsempfindliches Gemisch nach einem der Ansprüche 1 oder 2, dadurch gekennzeichnet, daß als Komponente (a) Poly-(-p-hydroxistyrol) oder Poly(p-hydroxi-α-methylstyrol) mit mittleren Molekulargewichten $\overline{M}_W$ zwischen 200 und 200 000 eingesetzt wird, wobei ein Teil der Hydroxylgruppen durch die Gruppierung (I) ersetzt ist.

**5.** Strahlungsempfindliches Gemisch nach einem der vorhergehenden Ansprüche, dadurch gekennzeichnet, daß mindestens 5 mol-% der das Bindemittel (a) aufbauenden Monomereinheiten die Gruppierung (I) aufweisen.

**6.** Strahlungsempfindliches Gemisch nach Anspruch 5, dadurch gekennzeichnet, daß Komponente (a) Gruppierungen (II) und (III)

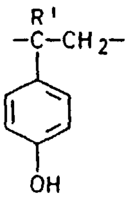 und 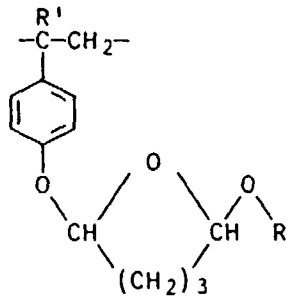

(II) (III)

enthält, wobei R die in Anspruch 1 angegebene Bedeutung hat und R' für H oder $CH_3$ steht.

**7.** Strahlungsempfindliches Gemisch nach einem der vorhergehenden Ansprüche, dadurch gekennzeichnet, daß als Komponente (b) ein Sulfonium- oder Jodoniumsalz der allgemeinen Formeln (IV) oder (V)

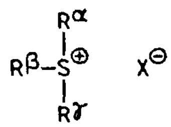 oder 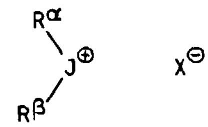

(IV) (V)

eingesetzt wird, worin $R^{\alpha}$, $R^{\beta}$ und $R^{\gamma}$ untereinander gleich oder verschieden sind und für Alkyl mit 1 bis 3 Kohlenstoffatomen, Aryl, substituiertes Aryl oder Aralkyl stehen und $X^{\ominus} = ClO_4^{\ominus}$, $AsF_6^{\ominus}$, $SbF_6^{\ominus}$, $PF_6^{\ominus}$ , $BF_4^{\ominus}$ und/oder $CF_3SO_3^{\ominus}$ ist.

**8.** Strahlungsempfindliches Gemisch nach Anspruch 7, dadurch gekennzeichnet, daß mindestens einer der Reste $R^{\alpha}$, $R^{\beta}$ und $R^{\gamma}$ für einen Rest der allgemeinen Formel (VI)

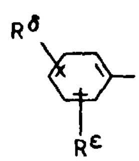 (VI)

steht, worin $R^{\delta}$ und $R^{\varepsilon}$ untereinander gleich oder verschieden sind und für H, OH, Alkyl oder Alkoxi mit jeweils 1 bis 4 Kohlenstoffatomen,

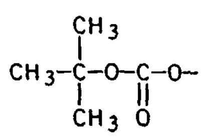 ,

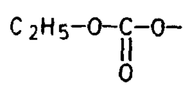 oder 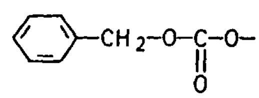

stehen.

**9.** Strahlungsempfindliches Gemisch nach einem der Ansprüche 1 bis 8, dadurch gekennzeichnet, daß Komponente (a) in einer Menge von 50 bis 99 Gew.-% und Komponente (b) in einer Menge von 1 bis 50 Gew.-% enthalten ist.

**10.** Strahlungsempfindliches Gemisch nach einem der vorhergehenden Ansprüche, dadurch gekennzeichnet, daß es zusätzlich einen Sensibilisator enthält, der Strahlung absorbiert und auf Komponente (b) überträgt.

**11.** Verfahren zur Herstellung von als Bindemittel (a) in strahlungsempfindlichen Gemischen gemäß einem der vorhergehenden Ansprüche geeigneten phenolischen Harzen, die Gruppierungen der Formel

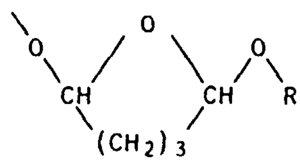

worin R für Alkyl mit 1 bis 5 Kohlenstoffatomen steht, enthalten, dadurch gekennzeichnet, daß phenolische Harze, die freie phenolische Hydroxylgruppen aufweisen, mit 3,4-Dihydro-2-alkoxipyran, das 1 bis 5 Kohlenstoffatome in der Alkoxigruppe enthält, unter Säurekatalyse umgesetzt werden.

**12.** Verfahren zur Herstellung lichtempfindlicher Beschichtungsmaterialien, dadurch gekennzeichnet, daß ein strahlungsempfindliches Gemisch gemäß einem der Ansprüche 1 bis 10 eingesetzt wird.

**13.** Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 130°C, bildmäßiges Belichten, Erhitzen auf Temperaturen von 70 bis 160°C und Entwickeln mit einer wäßrigalkalischen Lösung, dadurch gekennzeichnet, daß ein strahlungsempfindliches Gemisch nach einem der Ansprüche 1 bis 10 eingesetzt wird.

## Claims

**1.** A radiation-sensitive mixture consisting essentially of

(a) a water-insoluble binder or binder mixture which is soluble in aqueous alkali and
(b) a compound which forms a strong acid on irradiation,

wherein component (a) contains at least one group (I)

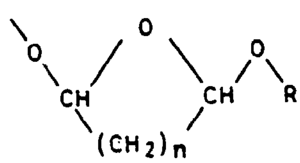

(I)

where R is alkyl of from 1 to 5 carbon atoms and n is 2, 3 or 4.

**2.** A radiation-sensitive mixture as claimed in claim 1, wherein component (a) is a phenolic resin whose ortho and/or para positions on the phenyl radicals are at least 20% free of substituents.

**3.** A radiation-sensitive mixture as claimed in either of the preceding claims, wherein component (a) is a mixture of a phenolic resin whose ortho and/or para positions on the phenyl radicals are at least 20% free of substituents and a novolak different therefrom.

**4.** A radiation-sensitive mixture as claimed in either of claims 1 and 2, wherein component (a) is poly-(p-hydroxystyrene) or poly (p-hydroxy-α-methylstyrene) having an average molecular weight $\overline{M}_n$ of from 200 to 200,000 in which some of the hydroxyl groups have been replaced by groups (I).

5. A radiation-sensitive mixture as claimed in any one of the preceding claims, wherein at least 5 mol% of the monomer units forming the binder (a) contain the group (I).

6. A radiation-sensitive mixture as claimed in claim 5, wherein component (a) contains groups (II) and (III)

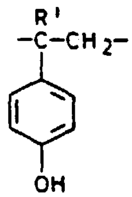

und

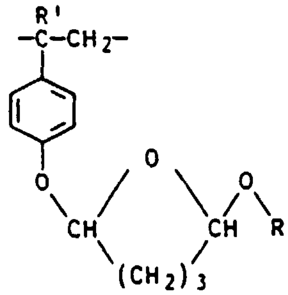

(II) (III)

where R is as defined in claim 1 and R' is H or $CH_3$.

7. A radiation-sensitive mixture as claimed in any one of the preceding claims, wherein component (b) is a sulfonium or iodonium salt of the general formula (IV) or (V)

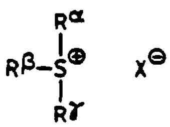

(IV)

or

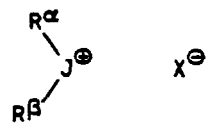

(V)

where $R^{\alpha}$, $R^{\beta}$ and $R^{\gamma}$ are identical or different and each is alkyl of 1 to 3 carbon atoms, aryl, substituted aryl or aralkyl, and $X^{\ominus} = ClO_4^{\ominus}$, $AsF_6^{\ominus}$, $SbF_6^{\ominus}$, $PF_6^{\ominus}$, $BF_4^{\ominus}$ and/or $CF_3SO_3^{\ominus}$.

8. A radiation-sensitive mixture as claimed in claim 7, wherein at least one of $R^{\alpha}$, $R^{\beta}$ and $R^{\gamma}$ is a radical of the general formula (VI)

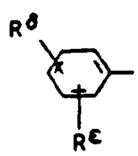

(VI)

where $R^{\delta}$ and $R^{\varepsilon}$ are identical or different and each is H, OH, or alkyl or alkoxy each of from 1 to 4 carbon atoms,

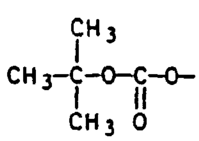

,

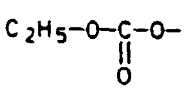

oder

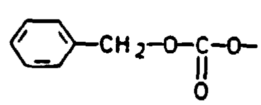

**9.** A radiation-sensitive mixture as claimed in claim 1 or 2 or 3 or 4 or 5 or 6 or 7 or 8, wherein component (a) is present in an amount of from 50 to 99% by weight and component (b) in an amount of from 1 to 50% by weight.

**10.** A radiation-sensitive mixture as claimed in any one of the preceding claims, which additionally includes a sensitizer which absorbs radiation and transfers it to component (b).

**11.** A process for preparing a phenolic resin which is suitable for use as a binder (a) in a radiation-sensitive mixture as claimed in any one of the preceding claims and which contains a group of the formula

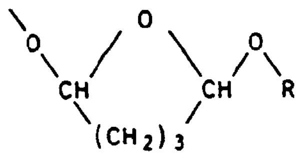

where R is alkyl of from 1 to 5 carbon atoms, which comprises reacting a phenolic resin which contains free phenolic hydroxyl groups with a 3,4-dihydro-2-alkoxypyran containing from 1 to 5 carbon atoms in the alkoxy group by acid catalysis.

**12.** A process for producing a light-sensitive coating material, which comprises using a radiation-sensitive mixture as claimed in claim 1 or 2 or 3 or 4 or 5 or 6 or 7 or 8 or 9 or 10.

**13.** A process for producing a relief structure by applying a radiation-sensitive mixture in a film thickness of from 0.1 to 5 µm to a conventionally pretreated substrate, drying at from 70 to 130°C, performing an imagewise exposure, heating to 70 to 160°C and developing with an aqueous alkali, which comprises using a radiation-sensitive mixture as claimed in claim 1 or 2 or 3 or 4 or 5 or 6 or 7 or 8 or 9 or 10.

**Revendications**

**1.** Mélange sensible à l'exposition à un rayonnement, consistant pour l'essentiel en

(a) un liant ou mélange de liants insoluble dans l'eau, soluble dans les solutions aqueuses alcalines, et
(b) un composé formant un acide fort lors de l'exposition à un rayonnement,

caractérisé par le fait que le composant (a) contient au moins un groupement

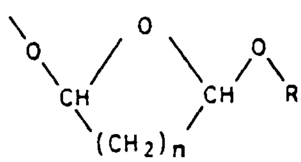

(I)

où R désigne un groupe alkyle ayant 1 à 5 atomes de carbone et n = 2, 3 ou 4.

**2.** Mélange sensible à l'exposition à un rayonnement selon la revendication 1, caractérisé par le fait qu'est introduite en tant que composant (a) une résine phénolique dont les positions ortho et/ou para sur les restes phényle sont exemptes de substituants pour au moins 20 %.

**3.** Mélange sensible à l'exposition à un rayonnement selon l'une des revendications précédentes, caractérisé par le fait qu'est introduit en tant que composant (a) un mélange d'une résine phénolique, dont les positions ortho et/ou para sur les restes phényle sont exemptes de substituants pour au moins 20 %, et d'une novolaque différente de celle-ci.

**4.** Mélange sensible à l'exposition à un rayonnement selon l'une des revendications 1 et 2, caractérisé par le fait qu'est mis en oeuvre en tant que composant (a) du poly-(p-hydroxystyrène) ou du poly-(p-hydroxy-α-méthylstyrène) ayant des masses moléculaires moyennes $\overline{M}_W$ entre 200 et 200 000, tandis qu'une partie des groupes hydroxyle est remplacée par le groupement (I).

**5.** Mélange sensible à l'exposition à un rayonnement selon l'une quelconque des revendications précédentes, caractérisé par le fait qu'au moins 5 % en moles des unités monomères constituant le liant (a) présentent le groupement (I).

**6.** Mélange sensible à l'exposition à un rayonnement selon la revendication 5, caractérisé par le fait que le composant (a) contient des groupements (II) et (III)

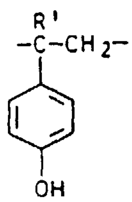

(II)

et

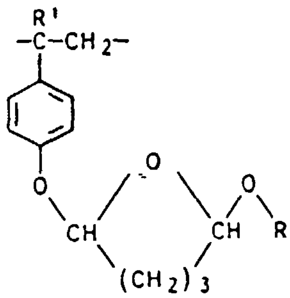

(III)

où R a la signification indiquée dans la revendication 1 et R' désigne H ou $CH_3$.

**7.** Mélange sensible à l'exposition à un rayonnement selon l'une quelconque des revendications précédentes, caractérisé par le fait qu'est introduit comme composant (b) un sel de sulfonium ou d'iodonium de formules générales (IV) ou (V)

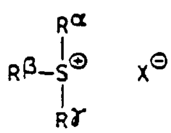

(IV)

ou

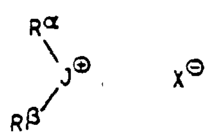

(V)

où $R^\alpha$, $R^\beta$ et $R^\gamma$ sont identiques entre eux ou différents et représentent un groupe alkyle ayant 1 à 3 atomes de carbone, aryle, aryle substitué ou aralkyle, et $X^\ominus = ClO_4^\ominus$, $AsF_6^\ominus$, $SbF_6^\ominus$, $PF_6^\ominus$, $BF_4^\ominus$ et/ou $CF_3SO_3^\ominus$.

**8.** Mélange sensible à l'exposition à un rayonnement selon la revendication 7, caractérisé par le fait qu'au moins l'un des restes $R^\alpha$, $R^\beta$ et $R^\gamma$ désigne un reste de formule générale (VI)

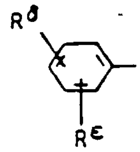

(VI)

où $R^\delta$ et $R^\varepsilon$ sont identiques entre eux ou différents et représentent H, OH, ou un groupe alkyle ou alcoxy ayant chacun 1 à 4 atomes de carbone

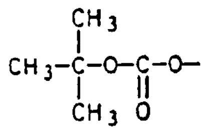

,

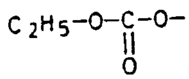

ou

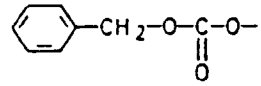

**9.** Mélange sensible à l'exposition à un rayonnement selon l'une quelconque des revendications 1 à 8, caractérisé par le fait que le composant (a) est contenu en une quantité de 50 à 99 % en poids et le composant (b) en une quantité de 1 à 50 % en poids.

**10.** Mélange sensible à l'exposition à un rayonnement selon l'une quelconque des revendications précédentes, caractérisé par le fait qu'il contient en outre un sensibilisateur qui absorbe le rayonnement et le transfère sur le composant (b).

**11.** Procédé pour la préparation de résines phénoliques appropriées comme liant (a) dans des mélanges sensibles à l'exposition à un rayonnement selon l'une quelconque des revendications précédentes, qui contiennent des groupements de formule

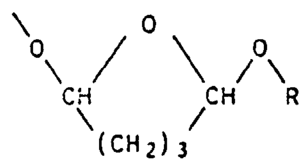

où R désigne un groupe alkyle ayant 1 à 5 atomes de carbone, caractérisé par le fait qu'on fait réagir sous catalyse acide des résines phénoliques qui présentent des groupes hydroxyle phénoliques libres, avec du 3,4-dihydro-2-alcoxypyranne qui contient 1 à 5 atomes de carbone dans le groupe alcoxy.

**12.** Procédé pour la préparation de matières d'enduction sensibles à la lumière, caractérisé par le fait qu'on utilise un mélange sensible à l'exposition à un rayonnement selon l'une quelconque des revendications 1 à 10.

**13.** Procédé pour la préparation de structures en relief par dépôt d'un mélange sensible à un rayonnement en une épaisseur de couche de 0,1 à 5 µm sur un substrat prétraité de manière classique, séchage à des températures de 70 à 130°C, éclairement selon une image, chauffage à des températures de 70 à 160°C et développement avec une solution aqueuse alcaline, caractérisé par le fait qu'on utilise un mélange sensible à l'exposition à un rayonnement selon l'une quelconque des revendications 1 à 10.